(19) Europäisches Patentamt
European Patent Office
Office européen des brevets

(11) **EP 4 557 607 A1**

(12) **DEMANDE DE BREVET EUROPEEN**

(43) Date de publication:
**21.05.2025   Bulletin 2025/21**

(21) Numéro de dépôt: **24213743.8**

(22) Date de dépôt: **18.11.2024**

(51) Classification Internationale des Brevets (IPC):
***H03B 5/36*** *(2006.01)*

(52) Classification Coopérative des Brevets (CPC):
**H03B 5/364; H03B 5/366;** H03B 2201/0266;
H03B 2201/0291

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH MA MD TN**

(30) Priorité:  **20.11.2023  FR 2312758**

(71) Demandeur: **STMicroelectronics International N.V.**
**1228 Plan-les-Ouates, Geneva (CH)**

(72) Inventeurs:
• **AYRAUD, Michel**
**38340 Voreppe (FR)**
• **RAMALHO TEIXEIRA JUNIOR, Fernando Jose**
**38000 Grenoble (FR)**

(74) Mandataire: **Cabinet Beaumont**
**4, Place Robert Schuman**
**B.P. 1529**
**38025 Grenoble Cedex 1 (FR)**

(54) **OSCILLATEUR ELECTRONIQUE A COMMANDES INDEPENDANTES DE CAPACITES VARIABLES**

(57)      La présente description concerne un oscillateur électronique (100) comprenant un résonateur (102) couplé en parallèle à au moins un circuit actif (104), le résonateur comprenant deux électrodes (110, 112) couplées à des capacités variables (116, 118) distinctes formant une capacité de charge de l'oscillateur électronique, et un dispositif de commande (148) configuré pour commander indépendamment les valeurs des capacités variables.

Fig 1

EP 4 557 607 A1

**Description**

Domaine technique

La présente description concerne de façon générale le domaine des oscillateurs électroniques.

Technique antérieure

Les oscillateurs électroniques utilisant des résonateurs à quartz sont très largement utilisés dans les SoCs (système sur puce), microcontrôleurs, dispositifs radio, etc., en particulier dans le domaine RF (radiofréquence). Le facteur de qualité important et la faible résistance électrique intrinsèque des résonateurs à quartz leur permettent de maintenir une oscillation stable avec une faible consommation électrique. Une architecture souvent utilisée pour de tels oscillateurs correspond à celle des oscillateurs Pierce.

Un ajustement fin de la fréquence d'oscillation d'un tel oscillateur est parfois nécessaire, par exemple dans certains systèmes tels que des systèmes UWB (*Ultra Wide Band,* connu sous le terme Ultra Large Bande en français) permettant, entre autres, une localisation précise d'objets. Cet ajustement de la fréquence d'oscillation est réalisé en jouant sur la valeur d'une capacité de charge couplée au résonateur de l'oscillateur. Cette capacité de charge peut être formée par plusieurs condensateurs répartis dans un ou plusieurs bancs de condensateurs. Ce ou ces bancs de condensateurs peuvent être intégrés sur une puce avec l'oscillateur.

Avec les oscillateurs existants, plus la précision requise pour l'ajustement de la valeur de la capacité de charge est importante, plus le nombre de condensateurs des bancs doit être important. Par exemple, lorsque le résonateur utilisé est de type MEMS piézoélectrique, la valeur requise pour la capacité de charge est généralement plus faible que pour un résonateur à quartz. Or, plus la valeur de la capacité de charge est faible, plus la variation de la fréquence d'oscillation de l'oscillateur sera importante pour une variation donnée de la capacité de charge. Cela se traduit par une précision d'ajustement de la valeur de la capacité de charge qui doit être plus importante.

Résumé de l'invention

Il existe un besoin de proposer un oscillateur électronique qui soit compatible notamment avec les technologies quartz et MEMS existantes et dans lequel un ajustement précis de la fréquence d'oscillation soit facilement réalisable.

Un mode de réalisation pallie tout ou partie des inconvénients des solutions connues et propose un oscillateur électronique comprenant un résonateur couplé en parallèle à au moins un circuit actif, le résonateur comprenant deux électrodes couplées à des capacités variables distinctes formant une capacité de charge de l'oscillateur électronique, et un dispositif de commande configuré pour commander indépendamment les valeurs des capacités variables.

Selon un mode de réalisation particulier, le dispositif de commande comporte un circuit numérique.

Selon un mode de réalisation particulier, chacune des capacités variables comporte un banc de condensateurs de valeurs différentes.

Selon un mode de réalisation particulier, chaque banc de condensateurs est configuré tel qu'une valeur de la capacité variable correspondante soit au moins égale à celle d'un premier condensateur du banc de condensateurs.

Selon un mode de réalisation particulier, chaque banc de condensateurs comporte en outre au moins un deuxième condensateur couplé à un interrupteur commandable par le dispositif de commande pour coupler ou non le deuxième condensateur en parallèle au premier condensateur du banc de condensateurs.

Selon un mode de réalisation particulier, les bancs de condensateurs des capacités variables comportent des condensateurs de valeurs identiques d'un banc de condensateurs à l'autre.

Selon un mode de réalisation particulier, le dispositif de commande comporte un additionneur configuré pour additionner un bit de poids faible d'un signal de commande codé sur plusieurs bits avec un nombre binaire formé des autres bits du signal de commande, et le dispositif de commande est configuré pour appliquer un signal de sortie de l'additionneur sur au moins une entrée de commande d'un premier des bancs de condensateurs et pour appliquer le nombre binaire sur au moins une entrée de commande d'un deuxième des bancs de condensateurs.

Selon un mode de réalisation particulier, le dispositif de commande comporte une LUT, ou un circuit de logique combinatoire synthétisée, ou un microcontrôleur.

Selon un mode de réalisation particulier, le résonateur correspond à un résonateur à quartz ou à un résonateur MEMS, ou résonateur de type microsystème électromécanique.

Selon un mode de réalisation particulier, le composant actif comporte un amplificateur inverseur.

Selon un mode de réalisation particulier, l'amplificateur inverseur comporte au moins un transistor MOS.

Selon un mode de réalisation particulier, l'amplificateur inverseur comporte en outre une impédance de contreréaction couplée au transistor MOS.

Selon un mode de réalisation particulier, les capacités variables sont chacune configurées pour que leur valeur puisse varier dans une gamme comprise entre 2 pF et 20 pF.

Il est également proposé un dispositif de transmission RF, comportant au moins un oscillateur électronique selon un mode de réalisation particulier.

Il est également proposé un procédé de commande d'un oscillateur électronique comprenant un résonateur couplé en parallèle à au moins un circuit actif, le résonateur comprenant deux électrodes couplées à des capacités variables distinctes formant une capacité de charge de l'oscillateur électronique, et un dispositif de commande configuré pour commander indépendamment les valeurs des capacités variables, dans lequel :

- le dispositif de commande comporte un circuit numérique, et

- chacune des capacités variables comporte un banc de condensateurs de valeurs différentes, et

- dans lequel le dispositif de commande comporte un additionneur configuré pour additionner un bit de poids faible d'un signal de commande codé sur plusieurs bits avec un nombre binaire formé des autres bits du signal de commande, et

dans lequel le procédé de commande comporte :

- réception du signal de commande en entrée de l'additionneur, puis

- addition, mise en oeuvre par l'additionneur, du bit de poids faible du signal de commande avec le nombre binaire formé des autres bits du signal de commande, puis

- application, par le dispositif de commande, d'un signal de sortie de l'additionneur sur au moins une entrée de commande d'un premier des bancs de condensateurs, et application du nombre binaire sur au moins une entrée de commande d'un deuxième des bancs de condensateurs.

Selon un mode de réalisation particulier, les entrées de commande des premier et deuxième des bancs de condensateurs sont des entrées de commande d'interrupteurs commandables.

Selon un mode de réalisation particulier :

- lorsque le bit de poids faible du signal de commande a pour valeur '0', le signal de sortie de l'additionneur est égal au nombre binaire formé par lesdits autres bits du signal de commande ;

- lorsque le bit de poids faible du signal de commande a pour valeur '1', le signal de sortie de l'additionneur est égal à la somme d'un bit '1' avec le nombre binaire formé par lesdits autres bits du signal de commande.

Selon un mode de réalisation particulier :

- lorsque le bit de poids faible du signal de commande a pour valeur '0', les valeurs des capacités variables sont identiques ;

- lorsque le bit de poids faible du signal de commande a pour valeur '1', les valeurs des capacités variables sont différentes l'une de l'autre.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 représente un oscillateur électronique selon un mode de réalisation particulier ;

la figure 2 représente une partie des éléments d'un oscillateur électronique selon un mode de réalisation particulier ;

la figure 3 et la figure 4 représentent des schémas électriques équivalents d'un résonateur utilisé dans un oscillateur électronique selon un mode de réalisation particulier ;

la figure 5 représente un schéma électrique équivalent d'un oscillateur électronique selon un mode de réalisation particulier ;

la figure 6 représente des exemples de valeurs de capacité de charge obtenues avec un oscillateur électronique selon un mode de réalisation particulier ; et

la figure 7 représente un dispositif de transmission RF comportant un oscillateur électronique selon un mode de réalisation particulier.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la réalisation de différents éléments et circuits, par exemple le résonateur, l'additionneur, les interrupteurs commandables etc., n'est pas détaillée. L'homme du métier sera à même de réaliser de manière détaillée les différents éléments et les différentes fonctions de l'oscillateur électronique décrit, à partir de la description fonctionnelle donnée ci-dessous.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments. De plus, dans l'ensemble de ce document, le terme « couplé » doit être compris comme signifiant « couplé électriquement ».

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures dans une position normale d'utilisation.

Sauf précision contraire, les expressions "environ", "approximativement", "sensiblement", et "de l'ordre de" signifient à 10 % près, de préférence à 5 % près.

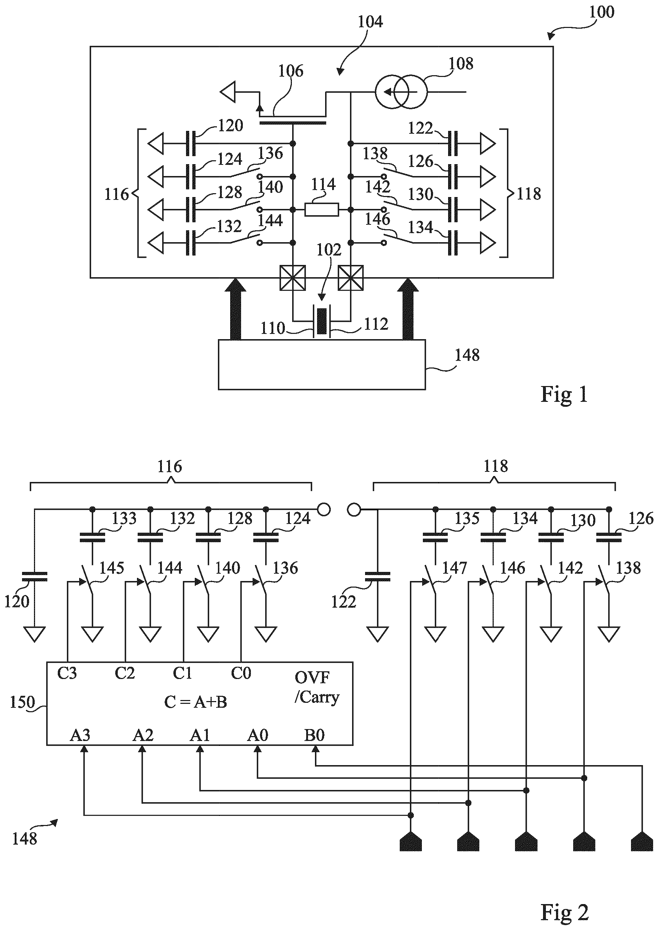

Un oscillateur électronique 100 selon un mode de réalisation particulier est décrit ci-dessous en lien avec la figure 1.

L'oscillateur électronique 100 comprend un résonateur 102. Le résonateur 102 correspond par exemple à un résonateur à quartz ou un résonateur MEMS piézoélectrique. Un tel résonateur MEMS piézoélectrique comporte par exemple une couche de silicium dopé recouverte d'une couche de matériau piézoélectrique tel que de l'AlN.

L'oscillateur électronique 100 comprend en outre un circuit actif 104, c'est-à-dire un circuit ou composant électronique fournissant un gain, couplé en parallèle au résonateur 102. Selon un exemple de réalisation, le circuit actif 104 correspond à un amplificateur inverseur comprenant au moins un transistor MOS 106, par exemple de type N, couplé à une source de courant 108. Sur l'exemple de la figure 1, le circuit actif 104 est couplé à deux électrodes 110, 112 du résonateur 102. Sur l'exemple de la figure 1, la grille du transistor 106 est couplée à l'électrode 110 du résonateur 102, et le drain du transistor 106 est couplé à l'électrode 112 du résonateur 102. Selon un exemple de réalisation, le transistor 106 peut être un transistor de type GO2 (c'est à dire comprenant un oxyde de grille épais), qui présente une bonne robustesse vis-à-vis des décharges électrostatiques. En variante, le transistor 106 peut être de type GO1. En variante, le circuit actif 104 peut comporter d'autres types de transistor.

Dans l'exemple de réalisation décrit, l'oscillateur électronique 100 comprend en outre une impédance de contre-réaction 114 couplée en parallèle au résonateur 102. Sur l'exemple de la figure 1, cette impédance de contre-réaction 114 correspond à une résistance électrique.

L'oscillateur électronique 100 décrit dans cet exemple correspond à un oscillateur Pierce. En variante, l'oscillateur électronique 100 pourrait être différent d'un oscillateur Pierce.

Les électrodes 110, 112 du résonateur 102 sont couplées à des capacités variables distinctes 116, 118 formant la capacité de charge de l'oscillateur électronique 100. Selon un mode de réalisation particulier, chacune des capacités variables 116, 118 comporte un banc de condensateurs pouvant avoir ou non des valeurs différentes les uns des autres.

Sur l'exemple de la figure 1, chaque banc de condensateurs des capacités variables 116, 118 comporte un premier condensateur 120, 122 dont la valeur correspond à la valeur minimale de chacune des capacités variables 116, 118. Dans l'exemple de réalisation décrit, ce premier condensateur 120, 122 de chacune des capacités variables 116, 118 reste toujours couplé au résonateur 102. Autrement dit, le couplage entre le premier condensateur 120, 122 de chacune des capacités variables 116, 118 et le résonateur 102 n'est pas interrompu lors du fonctionnement de l'oscillateur électronique 100. Dans cet exemple de réalisation, la valeur de chacun des premiers condensateurs 120, 122 est appelée « Cfixed ».

Sur l'exemple de la figure 1, l'une des deux électrodes de chacun des premiers condensateurs 120, 122 est couplée à l'une des électrodes 110, 112 du résonateur 102 et l'autre des deux électrodes de chacun des premiers condensateur 120, 122 est couplée à un potentiel électrique de référence de l'oscillateur électronique 100, par exemple la masse de l'oscillateur électronique 100.

Dans l'exemple de réalisation décrit, chaque banc de condensateurs des capacités variables 116, 118 comporte, en plus du premier condensateur 120, 122, au moins un deuxième condensateur couplé à un interrupteur commandable lui-même couplé à l'une des électrodes 110, 112 du résonateur 102. Dans l'exemple de réalisation décrit ici, chaque banc de condensateurs des capacités variables 116, 118 comporte plusieurs autres condensateurs chacun couplé à un interrupteur qui est commandable indépendamment des autres et qui est couplé à l'une des électrodes 110, 112 du résonateur 102. Sur l'exemple de la figure 1, chaque banc de condensateurs des capacités variables 116, 118 comporte un deuxième, un troisième et un quatrième condensateurs respectivement référencés 124, 128, 132 pour la capacité variable 116 et référencés 126, 130, 134 pour la capacité variable 118. Sur l'exemple de la figure 1, chacun des condensateurs 124 à 134 comporte une première électrode couplée électriquement au potentiel électrique de référence et une deuxième électrode couplée à un interrupteur commandable respectivement référencé 136, 138, 140, 142, 144 et 146. Ainsi, dans chacun des bancs de condensateurs des capacités variables 116, 118, chacun des condensateurs 124 à 134 peut être couplé en parallèle au premier condensateur 120, 122 suivant l'état ouvert ou fermé de l'interrupteur commandable 136 à 146 couplé à chacun de ces condensateurs 124 à 134.

Dans l'exemple de réalisation décrit, les condensateurs des bancs des capacités variables 116, 118 ont des valeurs identiques d'un banc à l'autre. Sur l'exemple de la figure 1, les valeurs des deuxièmes, troisièmes et quatrièmes condensateurs 124 à 134 sont respectivement égales à C, C/2 et C/4. Ainsi, dans cet exemple, chacune des capacités variables 116, 118 peut prendre, suivant l'état des interrupteurs commandables 136 à 146, l'une des valeurs suivantes : Cfixed, Cfixed + C/4, Cfixed + C/2, Cfixed + 3C/4, Cfixed + C, Cfixed + 5C/4, Cfixed + 3C/2, Cfixed + 7C/4.

Les valeurs C et Cfixed peuvent ici être choisies en fonction de la valeur requise de la capacité de charge de l'oscillateur électronique 100. Selon un exemple de réalisation, les valeurs C et Cfixed peuvent être choisies telles que les valeurs des capacités variables 116, 118 puissent varier dans une gamme comprise entre 2 pf et 20 pF, ce qui permet de faire varier la capacité de charge de l'oscillateur 100 avec une valeur comprise entre 1 pF et 10 pF.

L'oscillateur électronique 100 comporte en outre un dispositif de commande 148 configuré pour commander indépendamment les valeurs des capacités variables 116, 118, c'est-à-dire tel que les valeurs des capacités variables 116, 118 puissent être similaires ou différentes l'une de l'autre. Dans l'exemple de réalisation décrit, le dispositif de commande 148 est configuré pour envoyer des signaux de commande aux interrupteurs commandables 136 à 146 de chacune des capacités variables 116, 118.

Dans l'exemple de réalisation décrit, le dispositif de commande 148 comporte ou correspond à un circuit numérique. Sur l'exemple de la figure 1, le dispositif de commande 148 est configuré pour délivrer un premier signal de commande codé sur plusieurs bits pour commander les interrupteurs 136, 140, 144 du banc de condensateurs de la première capacité variable 116, et pour délivrer un deuxième signal de commande codé sur plusieurs bits pour commander les interrupteurs 138, 142, 146 du banc de condensateurs de la deuxième capacité variable 118.

Etant donné que les capacités variables 116, 118 sont commandées indépendamment l'une de l'autre, les valeurs des premier et deuxième signaux de commande envoyés par le dispositif de commande 148 peuvent être similaires lorsque les valeurs des capacités variables 116, 118 sont destinées à être similaires, ou être différents lorsque les valeurs des capacités variables 116, 118 sont destinées à être différentes l'une de l'autre.

Un autre exemple de réalisation des capacités variables 116, 118 et du dispositif de commande 148 est représenté sur la figure 2.

Dans cet autre exemple, chacune des capacités variables 116, 118 comporte un banc de condensateurs comprenant le premier condensateur 120, 122 de valeur « Cfixed » ainsi que des deuxième, troisième, quatrième condensateurs 124 à 134 ainsi qu'un cinquième condensateur 133, 135 ayant, dans cet autre exemple, des valeurs respectivement égales à C, 2C, 4C et 8C. Sur l'exemple de la figure 2, chacun des condensateurs 124 à 135 comporte une première électrode couplée électriquement au potentiel électrique de référence de l'oscillateur électronique 100 et une deuxième électrode couplée à un interrupteur commandable 136 à 147 (les cinquièmes condensateurs 133, 135 sont couplés aux interrupteurs commandables 145, 147). Ainsi, dans cet exemple, chacune des capacités variables 116, 118 peut prendre, suivant l'état des interrupteurs commandables 136 à 147, une valeur comprise entre Cfixed et Cfixed + 15C, avec des valeurs intermédiaires égales à Cfixed + a*C, a étant un nombre entier compris entre 1 et 14. Les valeurs C et Cfixed sont par exemple choisies telles que les valeurs des capacités variables 116, 118 puissent varier dans une gamme comprise entre 2 pf et 20 pF.

Dans cet autre exemple, le dispositif de commande 148 comporte un additionneur 150 configuré pour recevoir en entrée un signal de commande initial codé sur plusieurs bits (une entrée pour chaque bit du signal de commande initial). Dans l'exemple de réalisation décrit, le nombre de bits du signal de commande initial est égal au nombre de condensateurs de chaque banc de condensateurs des capacités variables 116, 118, soit 5 sur l'exemple de la figure 2. Dans cet exemple, l'additionneur 150 est configuré pour additionner un bit de poids faible du signal de commande initial avec un nombre binaire formé par les autres bits du signal de commande initial. En outre, dans l'exemple décrit, le dispositif de commande 148 est configuré pour appliquer un signal de sortie de l'additionneur 150 sur au moins une entrée de commande (une pour chaque bit dans l'exemple décrit) de la première capacité variable 116 afin de commander les interrupteurs commandables de cette première capacité variable 116. Dans cet exemple, un nombre binaire formé des bits du signal de commande initial autres que le bit de poids faible sont appliqués sur au moins une entrée de commande (une pour chaque bit dans l'exemple décrit) de la deuxième capacité variable 118 afin de commander les interrupteurs commandables de cette deuxième capacité variable 118. Dans l'exemple de réalisation décrit, le nombre de bits des signaux envoyés en entrée des capacités variables 116, 118 est égal au nombre d'interrupteurs commandables de chacun des bancs de condensateurs des capacités variables 116, 118.

Ainsi, sur l'exemple de la figure 2, l'additionneur 150 est configuré pour réaliser l'addition C = A + B, avec B correspondant au bit de poids faible du signal de commande initial, A correspondant au nombre binaire formé par les bits en entrée de l'additionneur 150 (qui correspond également au signal de commande envoyé à la deuxième capacité variable 118), et C correspondant au nombre binaire obtenu en sortie de l'additionneur 150 (qui forme le signal de commande envoyé à première capacité variable 116). Sur l'exemple de la figure 2, le bit de poids faible du signal de commande initial est appliqué sur une entrée « B0 » de l'additionneur 150, les autres bits de ce signal de commande initial sont appliqués sur des entrées « A0 », « A1 », « A2 » et « A3 » de l'additionneur 150, et le signal de sortie de l'additionneur 150 est délivré sur les sorties « C0 », « C1 », « C2 » et « C3 » de l'additionneur 150.

Ainsi, dans la configuration représentée sur la figure 2, lorsque le bit de poids faible du signal de commande initial appliqué sur l'additionneur 150 a pour valeur '0', le nombre binaire délivré en sortie de l'additionneur 150 est égal au nombre binaire formé par les autres bits du signal de commande initial et appliqué en entrée de l'additionneur 150. Dans ce cas, les signaux de commande appliqués sur les interrupteurs commandables des bancs de condensateurs des capacités variables 116, 118 sont identiques, ce qui a pour conséquence que les capacités variables 116, 118 ont une valeur identique. Lorsque le bit du signal de commande initial appliqué sur l'entrée B de l'additionneur 150 a pour valeur '1', le nombre binaire délivré sur les bits de la sortie C est égal à la somme d'un bit '1' avec le nombre binaire formé par les autres bits du signal de commande initial reçu par l'additionneur 150. Dans ce cas, les signaux de commande appliqués sur les interrupteurs commandables des bancs de condensateurs des capacités variables 116, 118 sont différents et les capacités variables 116, 118 ont des valeurs différentes telles que C116 = C118 + C, avec C116 et C118 correspondant respectivement aux valeurs des capacités variables 116 et 118. Afin d'éviter un problème en cas de dépassement de la capacité de l'additionneur 150 (situation d'« overflow » lorsque tous les bits appliqués en entrée sont à '1'), le dispositif de commande 148 peut comporter des portes OU en sortie de l'additionneur 150 afin de mettre à l'état '1' les sorties du dispositif de commande 148 dans un tel cas de figure.

On décrit ci-dessous plus en détail le fonctionnement de l'oscillateur électronique 100.

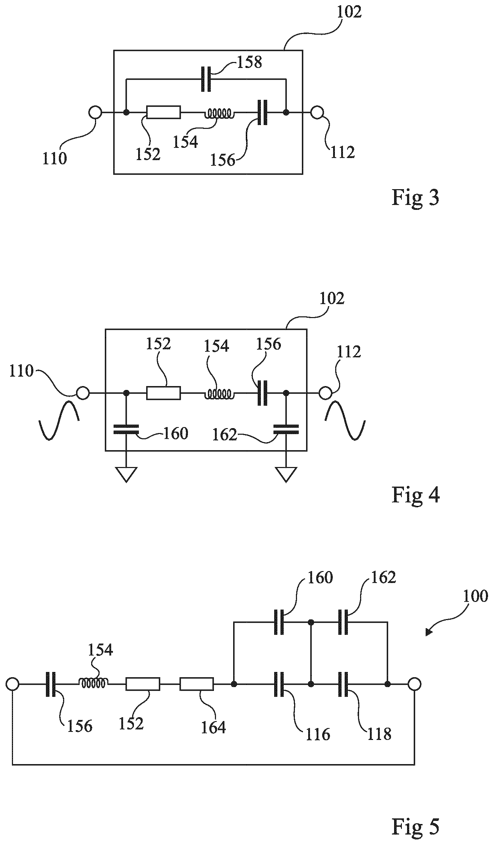

La figure 3 représente un schéma électrique équivalent du résonateur 102, ce schéma électrique étant applicable pour un résonateur 102 à quartz ou de type MEMS piézoélectrique. Le résonateur 102 peut être modélisé électriquement par une résistance 152, correspondant à la résistance série équivalente du résonateur 102, couplée électriquement en série entre la première électrode 110 du résonateur 102 et à une inductance 154 elle-même couplée électriquement en série à une première électrode d'une première capacité 156. La résistance 152 est représentative des pertes mécaniques du résonateur 102 et sa valeur est proportionnelle au facteur de qualité du résonateur 102 (plus faible dans le cas d'un résonateur de type MEMS piézoélectrique que pour un résonateur à quartz). L'inductance 154 est représentative de l'élasticité du résonateur 102, et la première capacité 156 est représentative de l'inertie mécanique du résonateur 102. Une deuxième électrode de la première capacité 156 est couplée à la deuxième électrode 112 du résonateur 102. Une deuxième capacité 158 est couplée électriquement en parallèle à l'ensemble formé par la résistance 152, l'inductance 154 et la première capacité 156. La deuxième capacité 158 est représentative de la capacité parasite du résonateur 102 (qui est associée à l'épaisseur du film piézoélectrique et sa permittivité diélectrique dans le cas d'un résonateur 102 de type MEMS piézoélectrique).

La figure 4 représente le schéma électrique équivalent du résonateur 102 lorsque celui-ci reçoit sur ses électrodes 110, 112 des signaux opposés ou en opposition de phase. Dans ce cas, la deuxième capacité 158 précédemment décrite en lien avec la figure 3 peut être vue comme formant deux capacités distinctes, référencées 160 et 162, comprenant chacune une électrode couplée à un potentiel électrique de référence correspondant par exemple à la masse du résonateur 102 ou à une masse virtuelle. La valeur de chacune des deux capacités 160, 162 est égale au double de celle de la capacité 158.

La figure 5 représente un schéma électrique équivalent de l'oscillateur électronique 100. Dans ce schéma électrique, outre les éléments du résonateur 102 précédemment décrits en lien avec la figure 4, le circuit actif 104 peut être modélisé électriquement par une résistance électrique négative 164 par exemple de valeur égale à $-Gm/((2C0+C116).(2C0+C118).2\pi.f)^2$, avec Gm correspondant à la transconductance du transistor 106 (dont la valeur est proportionnelle au courant de polarisation consommé) et f correspondant à la fréquence d'oscillation du résonateur 102. La fréquence d'oscillation $f_{osc}$ de l'oscillateur électronique 100 est égale à :

[Math 1]

$$f_{osc} = \frac{1}{2\pi\sqrt{Lm.Ceq}}$$

Avec Lm égale à la valeur de l'inductance 154, et Ceq la valeur de la capacité équivalente formée par les différentes capacités du schéma électrique de la figure 5, et qui est telle que :

[Math 2]

$$\frac{1}{Ceq} = \frac{1}{Cm} + \frac{1}{C116 + 2.C0} + \frac{1}{C118 + 2.C0}$$

Avec Cm correspondant à la valeur de la première capacité 156, et C0 correspondant à la valeur de la deuxième capacité 158.

L'oscillateur électronique 100 se trouve dans un état d'oscillation stable lorsque la somme des valeurs des résistances électriques 152 et 164 s'annule. Etant donné que les valeurs de Lm, Cm et CO ne sont pas modifiables, le réglage de la fréquence d'oscillation $f_{osc}$ de l'oscillateur électronique 100 est réalisé en réglant les valeurs des capacités variables 116, 118, ce qui revient à modifier la valeur de Ceq, et donc de $f_{osc}$. En considérant le schéma électrique équivalent de l'oscillateur électronique 100, plus la valeur de la résistance série équivalente 152 est grande, plus la valeur de la résistance électrique négative 164 doit être importante pour compenser la résistance 152, ce qui se traduit par une transconductance Gm plus importante (et donc plus de courant fourni par le transistor 106) ou un rapport (2C0+C116)/(2C0+C118) plus faible obtenu en ajustant les valeurs de C116 et C118 (la valeur C0 n'étant pas ajustable car elle dépend des caractéristiques physiques du résonateur 102) .

Ainsi, afin d'ajuster la fréquence d'oscillation de l'oscillateur électronique 100 pour compenser les possibles variations du résonateur 102 (généralement de +/- 10 ppm), les valeurs des capacités variables 116, 118 sont choisies en appliquant les signaux de commande souhaités en entrée de ces capacités, la valeur CL de la capacité de charge obtenue étant telle que CL = (C116+C118)/2. Ainsi, en considérant que la valeur de chacune des capacités variables 116, 118 puisse être ajustée avec un pas égal à 1 pF, la commande indépendante des valeurs des capacités variables permet ajuster la valeur CL avec un pas égal à 0,25 pF.

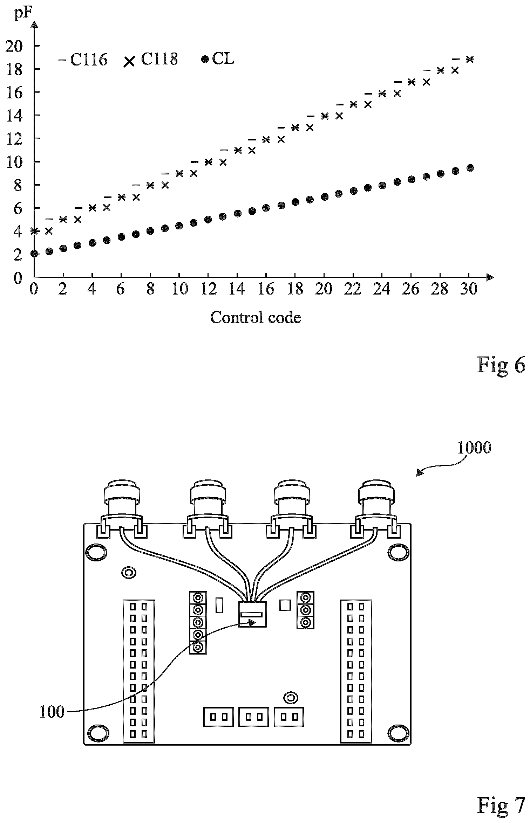

La figure 6 représente les valeurs de la capacité de charge CL obtenues avec des capacités variables 116, 118 telles que précédemment décrites en lien avec la figure 2, avec Cfixed = 4 pF et C = 1 pF. L'axe des abscisses représente la valeur du mot binaire appliqué en entrée de l'additionneur 150 et sur les entrées de commande de la deuxième capacité variable 118. Les valeurs obtenues de la capacité de charge CL forment une droite monotone bien adaptée pour un contrôle fin de la fréquence d'oscillation de l'oscillateur électronique 100. Sur l'exemple de la figure 6, avec un signal de commande de 4 bits, 31 valeurs différentes de la capacité de charge CL sont possibles.

Lorsque le résonateur 102 est de type MEMS, l'ensemble des composants de l'oscillateur 100 peuvent être réalisés au sein d'une même puce, par exemple de type SoC.

L'oscillateur électronique 100 propose une solution permettant d'augmenter la résolution d'ajustement de la fréquence d'oscillation de l'oscillateur via un ajustement indépendant de la valeur de chacune des capacités variables formant la capacité de charge de l'oscillateur électronique.

Un avantage de l'oscillateur électronique 100 décrit précédemment est que le résonateur 102 et/ou le circuit actif 104 et/ou les capacités variables 116, 118 peuvent correspondre à des éléments existants auxquels est ajouté le dispositif de commande 148. Par exemple, un avantage de faire appel à un dispositif de commande 148 numérique est que son ajout est plus simple que de modifier ou ajouter des éléments analogiques, par exemple ajouter des condensateurs aux bancs de condensateurs des capacités variables 116, 118.

Dans une configuration particulière, l'oscillateur électronique 100 peut présenter les avantages apportés par l'utilisation d'une structure d'oscillateur de type Pierce, c'est-à-dire notamment une faible consommation de courant électrique, un bruit réduit, un fonctionnement possible à haute fréquence et une bonne robustesse vis-à-vis des décharges électrostatiques.

L'oscillateur électronique 100 permet de garantir un caractère monotone des valeurs de capacité de charge pouvant être obtenues, sans complexifier son layout, ou design, et en faisant appel à un nombre de condensateurs réduit ou sans augmenter le nombre de condensateurs utilisés par rapport aux solutions existantes.

L'oscillateur électronique 100 peut s'appliquer au domaine RF et notamment à celui des SoCs RF, ou encore le domaine des émetteurs-récepteurs et/ou celui des dispositifs IoT (internet des objets) UWB / NB (bande étroite). La figure 7 représente un exemple de dispositif de transmission RF 1000, correspondant à un émetteur / récepteur UWB dans cet exemple, comprenant un oscillateur électronique 100 tel que précédemment décrit.

Dans les exemples précédemment décrits, l'oscillateur électronique 100 est de type Pierce. En variante, l'oscillateur 100 peut correspondre à un oscillateur d'un autre type. En outre, le circuit actif 104 peut être différent de celui précédemment décrit.

Le nombre de condensateurs formant les capacités variables, et donc également le nombre de bits utilisés pour commander les valeurs des capacités variables, peut être différent que ceux des exemples précédemment décrits.

Des dispositifs de commande 148 différents de celui précédemment décrit, c'est-à-dire comportant un ou plusieurs composants ou circuits électroniques autres qu'un additionneur, peuvent être utilisés pour remplir les mêmes fonctions que celles remplies par l'exemple de dispositif de commande 148 précédemment décrit. Par exemple, le dispositif de commande peut comporter une LUT (« Look Up Table » en anglais, ou table de recherche ou table de consultation), ou un circuit de logique combinatoire synthétisée, ou un microcontrôleur.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

**Revendications**

1. Oscillateur électronique (100) comprenant un résonateur (102) couplé en parallèle à au moins un circuit actif (104), le résonateur (102) comprenant deux électrodes (110, 112) couplées à des capacités variables (116, 118) distinctes formant une capacité de charge de l'oscillateur électronique (100), et un dispositif de commande (148) configuré pour commander indépendamment les valeurs des capacités variables (116, 118), dans lequel :

    - le dispositif de commande (148) comporte un circuit numérique, et
    - chacune des capacités variables (116, 118) comporte un banc de condensateurs (120 - 135) de valeurs différentes, et
    - dans lequel le dispositif de commande (148) comporte un additionneur (150) configuré pour additionner un bit de poids faible d'un signal de commande codé sur plusieurs bits avec un nombre binaire formé des autres bits du signal de commande, et
    - le dispositif de commande (148) est configuré pour appliquer un signal de sortie de l'additionneur (150) sur au moins une entrée de commande d'un premier des bancs de condensateurs (120, 124, 128, 132, 133) et pour appliquer le nombre binaire sur au moins une entrée de commande d'un deuxième des bancs de condensateurs (122, 126, 130, 134, 135).

2. Oscillateur électronique (100) selon la revendication 1, dans lequel chaque banc de condensateurs (120 - 135) est configuré tel qu'une valeur de la capacité variable (116, 118) correspondante soit au moins égale à celle d'un premier condensateur (120, 122) du banc de condensateurs (120 - 135).

3. Oscillateur électronique (100) selon la revendication 2, dans lequel chaque banc de condensateurs (120 - 135) comporte en outre au moins un deuxième condensateur (124 - 135) couplé à un interrupteur commandable (136 - 147) par le dispositif de commande (148) pour coupler ou non le deuxième condensateur (124 - 135) en parallèle au premier condensateur (120, 122) du banc de condensateurs (120 - 135) .

4. Oscillateur électronique (100) selon l'une des revendications précédentes, dans lequel les bancs de condensateurs (120 - 135) des capacités variables (116, 118) comportent des condensateurs (120 - 135) de valeurs identiques d'un banc de condensateurs (120 - 135) à l'autre.

5. Oscillateur électronique (100) selon l'une des revendications précédentes, dans lequel le résonateur (102) correspond à un résonateur à quartz ou à un résonateur de type microsystème électromécanique.

6. Oscillateur électronique (100) selon l'une des revendications précédentes, dans lequel le composant actif (104) comporte un amplificateur inverseur.

7. Oscillateur électronique (100) selon la revendication 6, dans lequel l'amplificateur inverseur comporte au moins un transistor MOS (106).

8. Oscillateur électronique (100) selon la revendication 7, dans lequel l'amplificateur inverseur comporte en outre une impédance de contreréaction (114) couplée au transistor MOS (106) .

9. Oscillateur électronique (100) selon l'une des revendications précédentes, dans lequel les capacités variables (116, 118) sont chacune configurées pour que leur valeur puisse varier dans une gamme comprise entre 2 pF et 20 pF.

10. Dispositif de transmission RF (1000), comportant au moins un oscillateur électronique (100) selon l'une des revendications précédentes.

11. Procédé de commande d'un oscillateur électronique (100) comprenant un résonateur (102) couplé en parallèle à au moins un circuit actif (104), le résonateur (102) comprenant deux électrodes (110, 112) couplées à des capacités variables (116, 118) distinctes formant une capacité de charge de l'oscillateur électronique (100), et un dispositif de commande (148) configuré pour commander indépendamment les valeurs des capacités variables (116, 118), dans lequel :

   - le dispositif de commande (148) comporte un circuit numérique, et
   - chacune des capacités variables (116, 118) comporte un banc de condensateurs (120 - 135) de valeurs différentes, et
   - le dispositif de commande (148) comporte un additionneur (150) configuré pour additionner un bit de poids faible d'un signal de commande codé sur plusieurs bits avec un nombre binaire formé des autres bits du signal de commande, et

   dans lequel le procédé de commande comporte :

   - réception du signal de commande en entrée de l'additionneur (150), puis
   - addition, mise en oeuvre par l'additionneur (150), du bit de poids faible du signal de commande avec le nombre binaire formé des autres bits du signal de commande, puis
   - application, par le dispositif de commande (148), d'un signal de sortie de l'additionneur (150) sur au moins une entrée de commande d'un premier des bancs de condensateurs (120, 124, 128, 132, 133), et application du nombre binaire sur au moins une entrée de commande d'un deuxième des bancs de condensateurs (122, 126, 130, 134, 135).

12. Procédé de commande selon la revendication 11, dans lequel les entrées de commande des premier et deuxième des bancs de condensateurs (120, 124, 128, 132, 133) sont des entrées de commande d'interrupteurs commandables (136 - 147) .

13. Procédé de commande selon l'une des revendications 11 ou 12, dans lequel :

   - lorsque le bit de poids faible du signal de commande a pour valeur '0', le signal de sortie de l'additionneur (150) est égal au nombre binaire formé par lesdits autres bits du signal de commande ;
   - lorsque le bit de poids faible du signal de commande a pour valeur '1', le signal de sortie de l'additionneur (150) est égal à la somme d'un bit '1' avec le nombre binaire formé par lesdits autres bits du signal de commande.

14. Procédé de commande selon la revendication 13, dans lequel :

   - lorsque le bit de poids faible du signal de commande a pour valeur '0', les valeurs des capacités variables (116, 118) sont identiques ;
   - lorsque le bit de poids faible du signal de commande a pour valeur '1', les valeurs des capacités variables (116, 118) sont différentes l'une de l'autre.

Fig 1

Fig 2

Fig 3

Fig 4

Fig 5

Fig 6

Fig 7

Europäisches Patentamt
European Patent Office
Office européen des brevets

## RAPPORT DE RECHERCHE EUROPEENNE

Numéro de la demande

EP 24 21 3743

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 6 559 730 B1 (MARVIN DENNIS F [US] ET AL) 6 mai 2003 (2003-05-06) * colonne 4, ligne 3 - ligne 7; figure 1; tableau 1 * * colonne 1, ligne 14 - ligne 25 * * colonne 2, ligne 1 - ligne 4 * | 1-6,8-14 | INV. H03B5/36 |
| X | US 11 171 625 B1 (SANKARAGOMATHI KANNAN [US] ET AL) 9 novembre 2021 (2021-11-09) * colonne 11, ligne 55 - colonne 12, ligne 19; figures 2, 4C * | 1-3,5-14 | |
| X | US 7 280 001 B2 (SILICON LAB INC [US]) 9 octobre 2007 (2007-10-09) * colonne 9, ligne 21 - ligne 23; figures 2,10 * * colonne 13, ligne 23 - ligne 28 * | 1-4,6-14 | |
| X | US 2018/198451 A1 (JUNG SANGDON [KR] ET AL) 12 juillet 2018 (2018-07-12) * alinéa [0092]; figure 7 * | 1-3,9-14 | |

DOMAINES TECHNIQUES RECHERCHES (IPC)

H03B

Le présent rapport a été établi pour toutes les revendications

| Lieu de la recherche | Date d'achèvement de la recherche | Examinateur |
|---|---|---|
| Munich | 2 avril 2025 | Schnabel, Florian |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

............................................................
& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 24 21 3743

La présente annexe indique les membres de la famille de brevets relatifs aux documents  brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

02-04-2025

| Document brevet cité au rapport de recherche | | Date de publication | Membre(s) de la famille de brevet(s) | | | Date de publication |
|---|---|---|---|---|---|---|
| US 6559730 | B1 | 06-05-2003 | AU | 6337201 | A | 14-01-2002 |
| | | | US | 6559730 | B1 | 06-05-2003 |
| | | | WO | 0203540 | A1 | 10-01-2002 |
| US 11171625 | B1 | 09-11-2021 | AUCUN | | | |
| US 7280001 | B2 | 09-10-2007 | AUCUN | | | |
| US 2018198451 | A1 | 12-07-2018 | KR | 20180082707 | A | 19-07-2018 |
| | | | US | 2018198451 | A1 | 12-07-2018 |

EPO FORM P0460

Pour tout renseignement concernant cette annexe : voir Journal Officiel de l'Office européen des brevets, No.12/82